# EUROPÄISCHE PATENTSCHRIFT

(11) **EP 0 955 666 B1**
(45) Veröffentlichungstag und Bekanntmachung des Hinweises auf die Patenterteilung: **07.03.2007**
(21) Anmeldenummer: 99105636.7
(22) Anmeldetag: 19.03.1999
(51) Int. Cl.: H01J 37/34

(54) **Zerstäubungskathode nach dem Magnetronprinzip**
Sputtering cathode according to the magnetron principle
Cathode de pulvérisation selon le principe magnétron

(30) Priorität: 04.05.1998 DE 19819785
(43) Veröffentlichungstag der Anmeldung: 10.11.1999
(73) Patentinhaber: Applied Materials GmbH & Co. KG, 63755 Alzenau (DE)
(72) Erfinder: Liehr, Michael Dr., 36325 Feldatal (DE); Krempel-Hesse, Jörg Dr., 63683 Eckartsborn (DE); Adam, Rolf, 63450 Hanau am Main (DE)
(74) Vertreter: Bockhorni, Josef

(56) Entgegenhaltungen:
- US-A- 4 180 450
- US-A- 4 448 653
- US-A- 4 904 362

## Beschreibung

Die Erfindung betrifft eine Zerstäubungskathode nach dem Magnetron-Prinzip mit einem aus mindestens einem Teil bestehenden Target aus dem zu zerstäubenden Material mit einem hinter dem Target angeordneten Magnetsystem mit Quellen unterschiedlicher Polung, durch die mindestens ein in sich geschlossener Tunnel aus bogenförmig gekrümmten Feldlinien gebildet wird, wobei die dem Target abgekehrten Pole der Quellen über ein Magnetjoch aus weichmagnetischem Material miteinander verbunden sind.

Bekannt ist eine Sputterkathode (US 4,461,688) mit einem plattenförmigen Target und mehreren, auf der de Substrat abgewandten Seite des Targets angeordneten U-förmigen Magneteinheiten, wobei die beiden Schenkel einer ersten U-förmigen Magneteinheit mit ihren Stirnflächen an den Randpartien der abgewandten Fläche des Targets anliegen und ein weiteres Paar von U-förmigen Magneteinheiten jeweils an einer Hälfte der abgewandten Targetfläche mit den Stirnflächen ihrer Schenkel anliegen und weitere zweite Paare von kleineren U-förmigen Magneteinheiten mit den Stirnflächen ihrer beiden Schenkel jeweils an der äußeren Hälfte der vom zweiten Paar Magneteinheiten übergriffenen Partie der abgewandten Fläche des Targets anliegen.

Bekannt ist weiterhin eine Sputterkathode (US 4,265,729), bei der auf der dem Substrat abgewandten Seite des Targets Magnete vorgesehen sind, deren die Magnetfelder bildenden Körper gerade Prismen sind, deren Grundkanten schräg zur Ebene des Targets verlaufen, wobei die Magnetisierungsachsen der Magnete parallel oder vertikal zu; Grundflächen der auf Kanten stehenden den Körper verlaufen.

Der vorliegenden Erfindung liegt die Aufgabe zugrunde, die vergleichsweise schlechte Targetausnutzung der planaren Sputterkathoden zu verbessern und damit die Beschichtungskosten zu verringern und die Anlagenstandzeit zu verlängern. Außerdem soll eine Belegung der die Targets auf ihrer Grundplatte haltenden Pratzleisten mit Schichtwerkstoff vermieden werden, um das Arcing und die Verunreinigung der Substrate durch abplatzendes Schichtmaterial zu verhindern.

Diese Aufgabe wird durch eine Zerstäubungskathode gemäß Anspruch 1 gelöst.

Eine bevorzugte Ausführungsform ist in Anspruch 2 definiert.

Die Erfindung läßt die verschiedensten Ausführungsformen zu; zwei davon sind in den anhängenden Zeichnungen schematisch dargestellt. Fig. 1a zeigt einen herkömmlichen Sputterkathodenaufbau im Querschnitt, bestehend aus dem Sputtertarget mit Rükkenplatte 3, den permanenten Magneten 2a und 2b sowie einem Joch aus weichmagnetischem Material 1 für den magnetischen Rückschluß. Entsprechend dem derzeitigen Stand der Technik verlaufen die Magnetisierungsachsen der permanenten Magnete entgegengesetzt parallel in vertikaler Richtung, wie in Fig. 1a durch Pfeile gekennzeichnet.

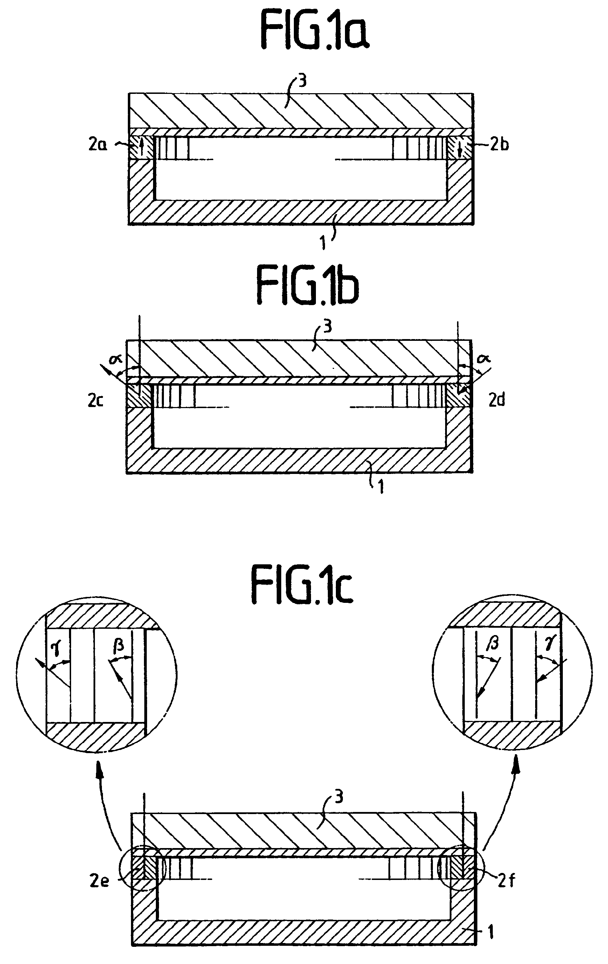

Eine verbesserte Ausnutzung des Targetmaterials kann erreicht werden, wenn die Magnetisierungsachsen der permanenten Magnete 2c und 2d um einen Winkel α gegen die vertikale Achse gedreht werden, wie in Fig. 1b gezeigt. Der jeweils optimale Drehwinkel α hängt von der Beschaffenheit (z. B. Materialstärke) des Sputtertargets 3 ab und hat eine Drehrichtung relativ zur vertikalen Achse derart, daß die Längen der magnetischen Kraftlinien im bzw. über dem Sputtertarget vergrößert werden. Die absoluten Beträge der Drehwinkel sind aus Symmetriegründen für beide Magnete der Sputterkathode gleich (Spiegelsymmetrie zur Kathodenmittelachse).

Eine weitere Verbesserung der Ausnutzung des Targetmaterials kann erreicht werden, wenn die permanenten Magnete 2a,2b oder 2c,2d durch jeweils zwei permanente Magnete halber Querschnittsfläche 2e und 2f ersetzt werden, wie in Fig. 1c gezeigt. Im Gegensatz zu der Vorrichtung gemäß Fig. 1b sind zwei verschiedene Drehwinkel β und γ der Magnetisierungsachsen vorgesehen, wobei die optimalen Drehwinkel von der Beschaffenheit des Sputtertargets abhängen. Durch die Verdopplung der Anzahl der Drehwinkel ergeben sich Vorteile bei der jeweiligen Anpassung des Magnetfelds auf das Sputtertarget. Die Drehrichtung beider Drehwinkel relativ zur vertikalen Achse ist so zu wählen, daß die Längen der magnetischen Kraftlinien im bzw. über dem Sputtertarget vergrößert werden, ähnlich wie die der Vorrichtung nach Fig. 1b. Die absoluten Beträge von zwei jeweils zur Mittelachse der Sputterkathode spiegelsymmetrisch gegenüberliegenden permanenten Magneten sind aus Symmetriegründen gleich.

## Patentansprüche

1. Zerstäubungskathode nach dem Magnetron-Prinzip mit einem aus mindestens einem Teil bestehenden Target deren Magnetisierungsachsen unterschiedliche Drehwinkel (β, γ) aufweisen aus dem zu zerstäubenden Material mit einem hinter dem Target angeordneten Magnetsystem mit Quellen (2a-2f) unterschiedlicher Polung, durch die mindestens ein in sich geschlossener Tunnel aus bogenförmig gekrümmten Feldlinien gebildet wird, wobei die die Quellen der Magnetfelder bildenden Permanentmagnete gerade Prismen, vorzugsweise Quader, sind, deren Grundkanten parallel der Targetebene ausgerichtet sind und die dem Target abgekehrten Pole der Quellen über ein Magnetjoch (1) aus weichmagnetischem Material miteinander verbunden sind, **dadurch gekennzeichnet, dass** die Magnetisierungsachsen der Quellen jeweils um einen Winkel (α, β, γ) gegen eine zu den Grundflächen der Permanentmagnete vertikale Achse gedreht sind.

2. Zerstäubungskathode nach Anspruch 1, **dadurch gekennzeichnet, dass** jede Quelle aus mindestens zwei Permanentmagneten (2e, 2f) zusammengefügt ist, deren Magnetisierungsachsen unterschiedliche Drehwinkel (β, γ) aufweisen.

## Claims

1. A sputtering cathode operating on the magnetron principle with a target (3), consisting of at least one piece, of the material to be sputtered with a magnet system, arranged behind the target, with sources (2a-2f) of different polarity, by which at least one closed tunnel of arcuate curved field lines is produced, wherein the permanent magnets producing the sources of the magnetic fields are straight prisms, preferably cuboidal blocks, whose base edges are aligned parallel to the target plane and the poles, directed away from the target, of the sources are connected together by means of a magnetic yoke (1) of soft magnetic material, **characterised in that** the axes of magnetisation of the sources are rotated through an angle (α, β, γ) with respect to an axis which is vertical to the base surfaces of the permanent magnets.

2. A sputtering cathode as claimed in Claim 1, **characterised in that** each source comprises at least two permanent magnets (2e, 2f) joined together, the axes of magnetisation of which have different angles of rotation (β, γ).

## Revendications

1. Cathode de pulvérisation selon le principe du magnétron comprenant une cible (3) composée au moins en partie du matériau à pulvériser, un système magnétique, disposé derrière la cible, comprenant des sources (2a à 2f) de polarité différente, par l'intermédiaire desquelles au moins un tunnel fermé en soi est formé par des lignes de champs courbées en arc, dans laquelle les aimants permanents formant les sources des champs magnétiques sont des prismes droits, de préférence des parallélépipèdes, dont les arêtes de base sont parallèles au plan de la cible, et les pôles des sources qui sont éloignés de la cible sont reliés entre eux par l'intermédiaire d'une culasse magnétique (1) faite d'un matériau magnétique doux, **caractérisée en ce que** les axes de magnétisation des sources sont chacun tournés selon un certain angle (α, β, γ) par rapport à un axe vertical aux surfaces des aimants permanents.

2. Cathode de pulvérisation selon la revendication 1, **caractérisée en ce que** chaque source est composée d'au moins deux aimants permanents (2e, 2f) dont les axes de magnétisation présentent différents angles de rotation (β, γ).
